# EUROPEAN PATENT APPLICATION

(11) **EP 3 486 955 A1**
(43) Date of publication of application: **22.05.2019**
(21) Application number: 17827744.8
(22) Date of filing: 14.07.2017
(51) Int. Cl.: H01L 31/12

(54) **PACKAGE FOR PHOTOSENSORS, PHOTOSENSOR DEVICE AND ELECTRONIC MODULE**

(30) Priority: 14.07.2016 JP 2016139501
(71) Applicant: KYOCERA Corporation, Kyoto 612-8501 (JP)
(72) Inventor: NAKAMOTO,Koutarou, Kyoto-shi Kyoto 612-8501 (JP)
(74) Representative: Viering, Jentschura & Partner mbB Patent- und Rechtsanwälte
(86) International application number: PCT/JP2017/025754
(87) International publication number: WO 2018/012621

(57) **Abstract**

A photosensor package includes a wiring board having a first main surface, a second main surface opposite to the first main surface, a first pore and a second pore that extend therethrough from the first main surface to the second main surface, the first pore having first opening in the first main surface and a second opening in the second main surface, the second pore having a third opening in the first main surface and a fourth opening in the second main surface, the fourth opening accommodating a light-emitting element that includes a light-emitting part, and a recess in the second main surface by which the first pore and the second pore are in communication with each other, the recess accommodating a light-receiving element that includes a light-emitting part; and a plurality of external connection conductors on the wiring board.

## Description

### Technical Field

The present invention relates to a photosensor package, a photosensor device, and an electronic module having a pair of openings in which sensor elements are accommodated and applicable to a proximity sensor device or the like.

### Background Art

Conventionally, a photosensor device such as a proximity sensor device is used in a portable terminal such as a portable telephone or a smartphone to detect a distance between the face of a user and the portable terminal. Such a photosensor device is, for example, a photosensor device that includes a light-emitting element such as an infrared-light emitting element and a light-receiving element such as an infrared-light receiving element that are on a substrate. Such a photosensor device includes a substrate that has a light-emitting-element recess for accommodating an infrared-light emitting element or the like and a light-receiving-element recess for accommodating an infrared-light receiving element or the like, the two recesses being disposed adjacent to each other; and such elements on the substrate.

A blocking part that is for blocking infrared light from an infrared-light emitting element or the like and that is constituted by a portion of a wiring board or a separately placed member is disposed between the light-emitting-element recess and the light-receiving-element recess adjacent to each other. Infrared light is emitted by the infrared-light emitting element in the light-emitting-element recess toward above the wiring board, and a portion of the emitted infrared light is reflected by a detection object such as the face of a user. The portion of the infrared light is detected by the infrared-light receiving element in the light-receiving-element recess, thereby enabling the distance between the detection object and a portable terminal to be detected. Whether the detection object is present close to the photosensor device is determined on the basis of presence/absence, strength, and the like of received light (refer to Japanese Unexamined Patent Application Publication (Translation of PCT Application) No. 2013-519995).

### Summary of Invention

### Technical Problem

The size and height of such a photosensor device is required to be reduced in accordance with recent progress in size reduction, height reduction, and multi-functionalization of portable terminals such as portable telephones and smartphones. For example, a photosensor device includes a substrate that has a light-emitting-element recess for accommodating an infrared-light emitting element or the like and a light-receiving-element recess for accommodating an infrared-light receiving element or the like, the two recesses being disposed adjacent to each other; and such elements on the substrate. In other words, an upper insulating layer including pores as these recesses, an intermediate insulating layer for accommodating the light-emitting element and the light-receiving element, and a lower insulating layer including external connection conductors on a lower surface thereof are required in order to suppress infrared light emitted by the light-emitting element from being directly detected by the light-receiving element and causing a malfunction. It is thus difficult to reduce the height of photosensor devices.

### Solution to Problem

A photosensor package according to an embodiment of the present invention includes a wiring board having a first main surface, a second main surface opposite to the first main surface, a first pore and a second pore extending therethrough from the first main surface to the second main surface, the first pore having a first opening in the first main surface and a second opening in the second main surface, the second pore having a third opening in the first main surface and a fourth opening in the second main surface, the fourth opening accommodating a light-emitting element including a light-emitting part, and a recess in the second main surface by which the first pore and the second pore are in communication with each other, the recess accommodating a light-receiving element including a light-receiving part; and a plurality of external connection conductors on the wiring board.

A photosensor device according to an embodiment of the present invention includes the photosensor package having the aforementioned configuration; a light-receiving element in the recess, the light-receiving element including a light-receiving part; and a light-emitting element disposed on the light-receiving element, the light-emitting element accommodated in the fourth opening, and including a light-emitting part.

An electronic module according to an embodiment of the present invention includes a module substrate including a connection conductor; and the photosensor device having the aforementioned configuration, the light-receiving element is disposed on the module substrate, and the plurality of external connection conductors are connected to the connection conductor.

### Advantageous Effects of Invention

According to an embodiment of the present invention, a photosensor package includes a wiring board having a first main surface, a second main surface opposite to the first main surface, a first pore and a second pore extending therethrough from the first main surface to the second main surface, the first pore having a first opening in the first main surface and a second opening in the second main surface, the second pore having a third opening in the first main surface and a fourth opening in the second main surface, the fourth opening accommodating a light-emitting element including a light-emitting part, and a recess in the second main surface by which the first pore and the second pore are in communication with each other, the recess accommodating a light-receiving element including a light-receiving part;
and a plurality of external connection conductors on the wiring board. Consequently, it is not necessary for the wiring board to include an intermediate insulating layer or an intermediate insulating part for accommodating the light-emitting element and the light-receiving element. It is thus possible to reduce the height of the wiring board.

In other words, it is possible to configure the wiring board so as to include an insulating layer or an insulating part having the first pore and the second pore and disposed on the first main surface and so as to include an insulating layer or an insulating part having the recess and disposed on the second main surface. Consequently, it is not necessary for the wiring board to include an intermediate insulating layer or an intermediate insulating part for accommodating the light-emitting element. It is thus possible to reduce the height of the wiring board.

According to an embodiment of the present invention, a photosensor device includes the photosensor package having the aforementioned configuration; a light-receiving element in the recess, the light-receiving element including a light-receiving part; and a light-emitting element disposed on the light-receiving element, the light-emitting element accommodated in the fourth opening, and including a light-emitting part. Consequently, it is possible to provide a low-height photosensor device that includes a wiring board including no intermediate insulating layer or no intermediate insulating part for accommodating the light-emitting element.

According to an embodiment of the present invention, an electronic module includes a module substrate including a connection conductor; and the photosensor device having the aforementioned configuration, the light-receiving element is disposed on the module substrate, and the plurality of external connection conductors are connected to the connection conductor. Consequently, it is possible to reduce the thickness of communication equipment such as smartphones by using the electronic module that includes the low-height photosensor device.

### Brief Description of Drawings

Fig. 1 is a sectional view of a photosensor package and a photosensor device according to an embodiment of the present invention.
Fig. 2 is a sectional view illustrating another example of the photosensor package and the photosensor device according to the embodiment of the present invention.
Fig. 3 is a sectional view illustrating another example of the photosensor package and the photosensor device according to the embodiment of the present invention.
Fig. 4 is a sectional view illustrating another example of the photosensor package and the photosensor device according to the embodiment of the present invention.
Fig. 5 is a sectional view illustrating another example of the photosensor package and the photosensor device according to the embodiment of the present invention.

### Description of Embodiments

A photosensor package, a photosensor device, and an electronic module according to an embodiment of the present invention will be described with reference to the attached drawings.

The photosensor package includes a wiring board 101 that has a rectangular shape in plan view. The wiring board 101 has a first pore 104 and a second pore 105 that extend therethrough from a first main surface 102 thereof to a bottom portion of a recess 106 of a second main surface 103. A light-receiving element 112 including a light-receiving part 111 is accommodated at the bottom portion of the recess 106 of the second main surface 103 such that a light-emitting element 114 is positioned at the bottom portion of the first pore 104 and the light-receiving part 111 is positioned at the bottom portion of the second pore 105.

The wiring board 101 includes wiring conductors (not illustrated) extending from the bottom portion of the recess 106 to an outer surface of the second main surface 103. The light-emitting element 114 is placed on a placement portion for the light-emitting element 114, the placement portion being disposed on an upper surface of the light-receiving element 112, and the light-receiving element 112 is accommodated in the recess 106, thereby constituting the photosensor package (including the wiring board 101 and external connection conductors 115) and a photosensor device 100 according to the embodiment of the present invention. If the light-receiving element 112 is placed in the recess 106 of the wiring board 101, the light-receiving part 111 is positioned at the bottom portion of the first pore 104 and the light-emitting element 114 disposed on the upper surface of the light-receiving element 112 is positioned at the bottom portion of the second pore 105.

The light-emitting element 114 including a light-emitting part 113 contains an emission element that emits physical energy such as infrared light, electromagnetic waves, or ultrasonic waves. The light-receiving element 112 including the light-receiving part 111 contains a detection element that detects such physical energy. The light-emitting element 114 and the light-receiving element 112 are used as a pair. The light-receiving element 112 is accommodated such that the light-emitting element 114 is in the first pore 104 of the wiring board 101 and the light-receiving part 111 is at the second pore 105. The light-emitting element 114 accommodated in the first pore 104 in the photosensor device 100 emits, for example, infrared light to the outside. If a detection object is present outside the photosensor device 100, that is, infrared light is emitted and if the detection object is present in the vicinity thereof in an opposing direction, the infrared light is reflected by the detection object and detected by the light-receiving part 111 at the bottom portion of the second pore 105. In contrast, if no detection object is present, the emitted infrared light is not reflected and not detected, and it is thus determined that no detection object is present.

In the following description, an example in which the light-emitting element 114 and the light-receiving element 112 are an infrared-light emitting element or an infrared-light receiving element capable of performing detection thereof will be mainly described. The light-emitting element 114 is an infrared-light emitting element or the like, and the light-receiving element 112 is an infrared-light receiving element or the like. The light-emitting element 114 and the light-receiving element 112, as a pair of sensor elements, operate as a functional component including the light-receiving element 112 as a main body that is made of a semiconductor material of gallium arsenide or the like and that has a quadrangular shape in plan view and including the light-emitting element 114 disposed on an upper surface of the light-receiving element 112 as the main body, the functional component emitting or receiving light through photoelectric conversion. Electric power supplied via the wiring conductors to the light-emitting element 114 is photoelectrically converted by the light-emitting element 114, and infrared light is emitted. Infrared light reflected by a detection object is detected by the light-receiving part 111 and converted into an electric signal. The electric signal is transmitted via the wiring conductors to an external electric circuit (not illustrated), for example, a detection circuit, a circuit for displaying on a display, or the like.

The wiring board 101 serves as a container for accommodating the light-receiving element 112 for light reception and also serves as a base substrate on which the wiring conductors that electrically connect the light-receiving element 112 to the external electric circuit are disposed. The wiring board 101 thus has the first pore 104 and the second pore 105 that serve as a pair of pores for accommodating the pair of sensor elements for light emission and light reception.

The light-emitting element 114 is connected to the upper surface of the light-receiving element 112 including the light-receiving part 111 by, for example, a low-melting-point brazing material, wire bonding, or the like so as to be away from the light-receiving part 111. The light-receiving element 112 including the light-receiving part 111 is connected via a bonding material, for example, glass, a low-melting-point brazing material, a conductive bonding material, or the like to the bottom portion of the recess 106 in the second main surface 103.

If a portion that serves as the base substrate is made of, for example, an aluminum oxide-based sintered body, the wiring board 101 can be manufactured by producing a plurality of ceramic green sheets by forming, into a sheet shape, ceramic slurry that is produced by kneading raw material powder such as aluminum oxide and silicon oxide together with a suitable organic binder and an organic solvent, and by firing the ceramic green sheets at a temperature of approximately 1600 °C in a reducing atmosphere after stacking these ceramic green sheets.

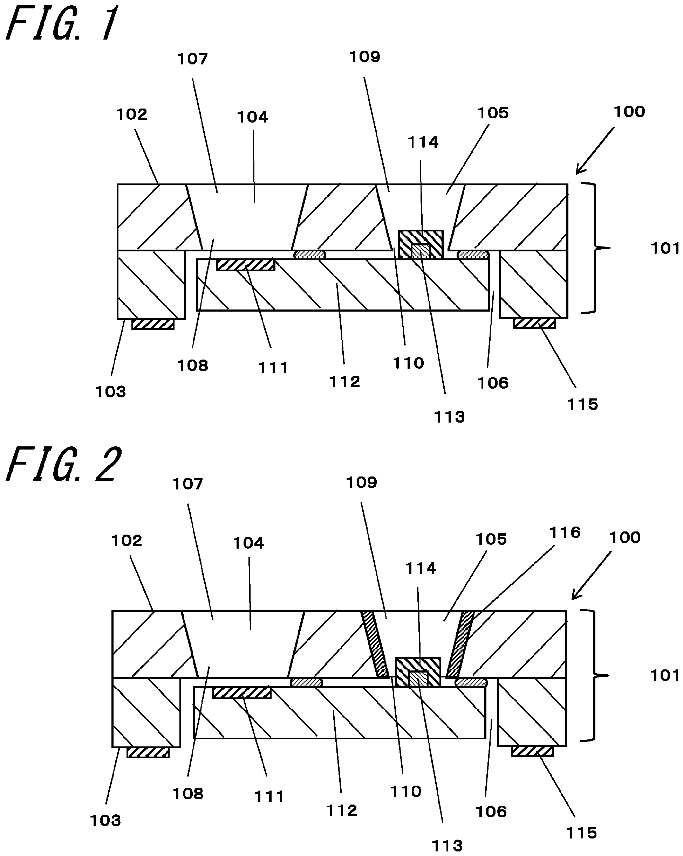

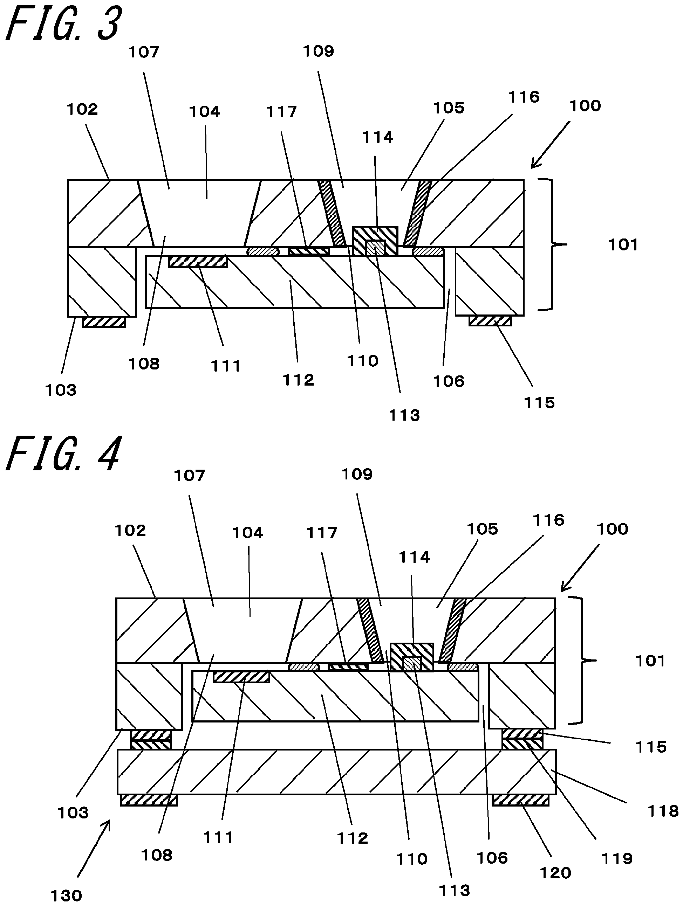

The wiring board 101 may be formed as a motherboard on which a plurality of wiring board regions is arrayed. If the wiring conductors are made of tungsten, molybdenum, or the like, the wiring board 101 that constitutes an electronic component accommodating package such as those illustrated in Figs. 1 to 3 is manufactured by dividing such a motherboard after a plating layer of nickel, gold, or the like is deposited on exposed wiring conductors.

The first pore 104 and the second pore 105 in the wiring board 101 can be formed, for example, as follows. A ceramic green sheet having two pores is produced by forming pores of, for example, a circular shape in a portion of a ceramic green sheet that serves as the first main surface 102 of the wiring board 101 by punching or the like. The shape of the pores is not limited to a circular shape and may be an oval shape, a rectangular shape, or a rounded rectangular shape. Next, a frame-shaped ceramic green sheet is produced by forming a portion of a ceramic green sheet that serves as the second main surface 103 of the wiring board 101 into a frame shape by punching or the like to form the recess 106. The wiring board 101 that constitutes such a photosensor package can be manufactured by stacking the ceramic green sheet that serves as the first main surface 102 on the ceramic green sheet that serves as the second main surface 103 so as to be in close contact with each other.

An example in which a structure of such a photosensor package is manufactured by producing the ceramic green sheets from the ceramic slurry that is produced by kneading raw material powder such as aluminum oxide and the like together with the suitable organic binder and the organic solvent and stacking the plurality of ceramic green sheets is presented in the aforementioned description; however, the wiring board 101 may be made of an organic resin material. If the wiring board 101 is made of an organic resin material, the structure can be produced by filling a mold that has been processed to have a shape and dimensions for forming the first pore 104, the second pore 105, and the recess 106 with an organic resin material (uncured) and heating and curing the organic resin material.

The photosensor package according to an embodiment of the present invention includes the wiring board 101 and the plurality of external connection conductors 115 on the wiring board 101. The wiring board 101 has the first main surface 102, the second main surface 103 opposite to the first main surface 102, the first pore 104 and the second pore 105 that extend therethrough from the first main surface 102 to the second main surface 103, and the recess 106 in the second main surface 103 by which the first pore 104 and the second pore 105 are in communication with each other. The first pore 104 has a first opening 107 in the first main surface 102 and a second opening 108 in the second main surface 103. The second pore 105 has a third opening 109 in the first main surface 102 and a fourth opening 110 in the second main surface 103. The recess 106 accommodates the light-receiving element 112 including the light-receiving part 111. The fourth opening 110 accommodates the light-emitting element 114 including the light-emitting part 113.

Due to such a structure, it is not necessary for the wiring board 101 to include an intermediate insulating layer or an intermediate insulating part for accommodating the light-emitting element 114 and the light-receiving element 112. It is thus possible to reduce the height of the wiring board 101. In other words, it is possible to configure the wiring board 101 so as to include an insulating layer or an insulating part having the first pore 104 and the second pore 105 and disposed on the first main surface 102 and so as to include an insulating layer or an insulating part having the recess 106 and disposed on the second main surface 103. Consequently, it is not necessary for the wiring board 101 to include an intermediate insulating layer or an intermediate insulating part for accommodating the light-emitting element 114. It is thus possible to reduce the height of the wiring board 101.

Fig. 1 is a sectional view of the photosensor package (including the wiring board 101 and the external connection conductors 115) and the photosensor device 100 according to an embodiment of the present invention. The insulating layer on the first main surface 102 of the wiring board 101 has the first pore 104 and the second pore 105 extending through the wiring board 101 from the first main surface 102 to the second main surface 103. The insulating layer on the second main surface 103 of the wiring board 101 has the recess 106 by which the first pore 104 and the second pore 105 are in communication with each other. The first pore 104 has the first opening 107 in the first main surface 102 and the second opening 108 in the second main surface 103. The second pore 105 has the third opening 109 in the first main surface 102 and the fourth opening 110 in the second main surface 103.

The recess 106 accommodates the light-receiving element 112 including the light-receiving part 111. The light-receiving element 112 is accommodated in the recess 106 by, for example, flip-chip connection such as that illustrated in Fig. 1. The light-receiving element 112 includes a plurality of solder bumps, as electric connection means, on the main surface thereof facing the recess 106. The recess 106 includes a plurality of wiring conductors (not illustrated) on the inner surface thereof and to which the light-receiving element 112 is connected.

The light-receiving part 111 is disposed at a position in the light-receiving element 112 facing the first pore 104. A pair of wiring conductors (not illustrated) on which the light-emitting element 114 is placed is disposed on the main surface of the light-receiving element 112 facing the recess 106 so as to avoid the region in which the solder bumps are disposed and so as to be at a location positioned at the second pore 105. The plurality of wiring conductors extends from the bottom portion of the recess 106 of the wiring board 101 to the second main surface 103. Portions of the wiring conductors exposed on the second main surface 103 serve as the external connection conductors 115.

The light-receiving element 112 including the light-receiving part 111 is accommodated at the bottom portion of the recess 106 by, for example, flip connection, thereby constituting a photosensor package that includes the wiring board 101 in which the light-receiving element 112 including the light-receiving part 111 is accommodated in the recess 106 and in which the light-emitting element 114 including the light-emitting part 113 is accommodated in the fourth opening 110, and that includes the plurality of external connection conductors 115 on the wiring board 101.

The light-emitting element 114 is constituted by an element such as a gallium-arsenide (Ga-As) light-emitting diode (infrared light), an ultrasonic oscillator (ultrasonic waves), or a microwave oscillator (electromagnetic waves). The light-receiving element 112 is a photodiode (infrared light), an ultrasonic oscillator (ultrasonic waves), a microwave detection element (electromagnetic waves), or the like. The light-receiving element 112 is constituted by an element of a semiconductor material such as gallium arsenide. The light-receiving element 112 having a quadrangular shape in plan view and the light-emitting element 114 disposed on the upper surface (first main surface 102 side) of the light-receiving element 112 operate as a functional component that emits or receives light through photoelectric conversion. Due to the light-emitting element 114 and the light-receiving element 112, as a pair of sensor elements, electric power supplied via the wiring conductor 101 to the light-emitting element 114 is photoelectrically converted by the light-emitting element 114, and infrared light is emitted. Infrared light reflected by a detection object is detected by the light-receiving part 111 and converted into an electric signal. The electric signal is transmitted via the wiring conductors (not illustrated) to the external electric circuit (not illustrated) such as a detection circuit or a circuit for displaying on a display.

Fig. 1 illustrates an example in which a terminal (not illustrated) of the light-emitting element 114 is connected to a connection terminal (not illustrated) of the light-receiving element 112; however, such a structure is a non-limiting example. For example, a step portion (not illustrated) may be disposed on an inner wall of the second pore 105 of the ceramic green sheet that serves as the first main surface 102, a connection terminal for bonding (not illustrated) may be disposed on the step portion, and the terminal of the light-receiving element 112 and the connection terminal for bonding on the step portion may be connected to each other by wire bonding. Such a connection method enables the connection terminal for bonding on the wiring board 101 and the terminal of the light-receiving element 112 to be favorably connected to each other. Moreover, if an illuminance sensor (not illustrated) is placed on the step portion, it is possible to provide a proximity-illuminance integrated sensor device (not illustrated) that has a proximity sensing function and an illuminance sensing function that controls backlight of a liquid crystal screen to detect illuminance and save electric power.

The photosensor package according to the embodiment of the present invention preferably has a metal layer 116 on an inner surface of the second pore 105. Due to such a structure, if electric power supplied via the wiring conductor 101 to the light-emitting element 114 is photoelectrically converted by the light-emitting element 114 and infrared light is emitted, the infrared light is reflected by the metal layer 116 on the inner surface of the second pore 105 and efficiently collected.

In other words, infrared light emitted by the light-emitting element 114 is reflected by the metal layer 116 and is not easily absorbed by the wiring board 101 even if being emitted onto the inner surface of the second pore 105. Accordingly, it is possible for the light-emitting element 114 to efficiently emit infrared light onto a detection object. Infrared light reflected by a detection object also has high intensity, and the infrared light thus is detected by the light-receiving part 111 and converted into an electric signal.

To dispose the metal layer 116 on the inner surface of the second pore 105, a pore having, for example, a circular shape is formed by a method such as punching in, for example, a portion of the ceramic green sheet that serves as the first main surface 102 of the wiring board 101, thereby producing the ceramic green sheet that has the second pore 105. Next, a plate having a pore equivalent to the formed second pore 105 is prepared, and, after the pore of the plate is positioned at the ceramic green sheet so as to cover the second pore 105, metalized paste that serves as the metal layer 116 is sucked by a suction method through the pore of the plate and applied onto the inner surface of the second pore 105. The method of disposing the metal layer 116 is not limited to the suction method. Other methods such as a screen printing method, a vapor deposition method, or the like may be used.

The metal layer 116 is also made of tungsten, molybdenum, or the like as is the other wiring conductors. A plating layer of nickel, gold, or the like is deposited on an exposed portion of the metal layer 116. The metal layer 116 may be constituted by a plating layer that differs from those of the other wiring conductors. For example, if the metal layer 116 is constituted by a silver plating layer, a reflection efficiency is improved, and it is thus possible for the metal layer 116 to collect infrared light more effectively with improved efficiency.

Preferably, the width of the first opening 107 is larger than the width of the second opening 108 and the width of the third opening 109 is larger than the width of the fourth opening 110 in the photosensor package according to the embodiment of the present invention. Due to such a structure, it is possible to improve detection sensitivity with respect to a detection object as a result of the interaction between the light-emitting element 114 and the light-receiving element 112, as a pair of sensor elements.

In other words, if infrared light is emitted toward above the wiring board 101 by the light-emitting element 114 in the second pore 105, it is possible for the infrared light to be efficiently emitted onto a detection object due to the structure of the second pore 105 in which the width of the third opening 109 is larger than the width of the fourth opening 110. A portion of the infrared light emitted by the light-emitting element 114 is reflected by a detection object such as the face or the like of a user, and, due to the structure of the first pore 104 in which the width of the first opening 107 is larger than the width of the second opening 108, it is possible for the infrared light to be more efficiently received by the light-receiving element 112. It is thus possible to detect the distance between a detection object and a portable terminal or the like with improved detection sensitivity.

Due to the width of the first opening 107 being larger than the width of the second opening 108 and the width of the third opening 109 being larger than the width of the fourth opening 110, it is possible to increase the placement region of the light-receiving element 112 if the light-receiving element 112 including the light-receiving part 111 is placed in the recess 106. It is thus possible to improve mounting reliability. Moreover, if a light-blocking body 117, which will be described later, is disposed between the second opening 108 and the fourth opening 110 in the recess 106, it is possible to increase the region in which the light-blocking body 117 is disposed. It is thus possible to further suppress occurrence of a malfunction as a result of a portion of infrared light emitted by the light-emitting element 114 being directly received by the light-receiving element 112.

To provide the structure of the first pore 104 in which the width of the first opening 107 is larger than the width of the second opening 108 and the structure of the second pore 105 in which the width of the third opening 109 is larger than the width of the fourth opening 110, a pore that has, for example, a circular shape is formed by a method such as punching in, for example, a portion of the ceramic green sheet that serves as the first main surface 102 of the wiring board 101 to produce a ceramic green sheet having the first pore 104 and the second pore 105. A punch that has a shape having a structure in which two columns having different diameters are connected to each other may be used for the punching so that the first pore 104 and the second pore 105 are formed by a distal end portion (small-diameter portion) of the punch and so that a narrow part (border part between the small-diameter portion and a large-diameter portion) of an upper punch is inserted into the ceramic green sheet as a result of being pressed. According to such a manufacturing method, one step portion is disposed on an inner wall of the first pore 104 and it is possible to provide the structure of the first pore 104 in which the width of the first opening 107 is larger than the width of the second opening 108, and one step portion is disposed on the inner wall of the second pore 105 and it is possible to provide the structure of the second pore 105 in which the width of the third opening 109 is larger than the width of the fourth opening 110.

In the aforementioned example, the distal end portion of the punch has the structure in which the two columns having different diameters are connected to each other; however, a punch or the like having another shape may be used. For example, it is possible to form multiple step portions on the inner walls of the first pore 104 and the second pore 105 by using a punch having a distal end that has a structure in which three or more columns are connected together. The greater the number of the step portions of the inner wall of each pore, the smaller the width of the step portions of each pore in plan view. Consequently, infrared light reflection efficiency is improved in the second pore 105, and it is thus possible to emit infrared light onto a detection object more effectively. In addition, it is possible for the light-receiving element 112 to receive the infrared light reflected by the detection object in the first pore 104 more efficiently, and it is thus possible to detect the distance between the detection object and a portable terminal or the like with further improved detection sensitivity.

Preferably, the width of the first pore 104 increase gradually from the second opening 108 to the first opening 107, and the width of the second pore 105 increase gradually from the fourth opening 110 to the third opening 109, respectively, in the photosensor package according to the embodiment of the present invention. Due to such a structure, it is possible to further improve the detection sensitivity with respect to a detection object as a result of the interaction between the light-emitting element 114 and the light-receiving element 112, as a pair of sensor elements.

In other words, due to the structure in which the width of the first pore 104 increases gradually from the second opening 108 to the first opening 107, and in which the width of the second pore 105 increases gradually from the fourth opening 110 to the third opening 109, it is possible to emit infrared light onto a detection object more efficiently if the infrared light is emitted toward above the wiring board 101 by the light-emitting element 114 in the second pore 105. Moreover, due to the structure in which the width of the first pore 104 increases gradually from the second opening 108 to the first opening 107, it is possible for the light-receiving element 112 to furthermore efficiently receive a portion of infrared light emitted by the light-emitting element 114, the portion being reflected by a detection object such as the face or the like of a user, and it is thus possible to detect the distance between a detection object and a portable terminal or the like more effectively with improved detection sensitivity.

The structure in which the width of the first pore 104 increases gradually from the second opening 108 to the first opening 107, and in which the width of the second pore 105 increases gradually from the fourth opening 110 to the third opening 109 is formed by, for example, adjusting the size of the clearance between the upper punch (actual punching-start portion of the aforementioned mold) (not illustrated) for forming each pore that serves as the first pore 104 or the second pore 105 and a pore (disposed in the mold that is arranged below the upper punch and on the upper surface of which the ceramic green sheet is placed) into which the upper punch is inserted, if the ceramic green sheet having the first pore 104 and the second pore 105 is produced by forming by a method such as punching a pore of, for example, a circular shape in a portion of the ceramic green sheet that serves as the first main surface 102 of the wiring board 101. The larger the clearance, the more inclined the inner wall of each of the first pore 104 and the second pore 105. It is thus possible to form the structure in which the width of the first pore 104 increases gradually from the second opening 108 to the first opening 107, and in which the width of the second pore 105 increases gradually from the fourth opening 110 to the third opening 109.

Details are as follows. Punching is started at the upper surface of the ceramic green sheet that serves as the first main surface 102 such that an area of punching is equivalent to the area of the upper punch that comes into contact with the upper surface. The area of punching at the lower surface of the ceramic green sheet is larger than the area of the upper punch. In other words, the ceramic sheet is placed on the mold (not illustrated) that has the pore into which the upper punch is inserted, pressure is applied to insert the upper punch into the pore of the mold, and a shearing force is thereby generated between the peripheral edge of the upper punch and the pore of the mold. Due to the shearing force, the inner wall of each pore punched in the ceramic green sheet has an inclined angle. The inner wall of the first pore 104 and the inner wall of the second pore 105 that are formed as described above include no step portion and each have the structure in which the width increases gradually.

The inclined angle of the inner wall of the first pore 104 and the inclined angle of the inner wall of the second pore 105 may differ from each other. For example, if the angle of the inner wall of the second pore 105 at which the light-emitting element 114 is positioned is increased, infrared light collecting properties are improved, and it is possible to increase the intensity of the infrared light reflected by a detection object. If the angle of the inner wall of the first pore 104 at which the light-receiving part 111 of the light-receiving element 112 is positioned is increased, infrared light is not easily blocked by a portion of the wiring board 101 even if the angle of the infrared light that enters the first opening 107 is changed by being reflected by a detection object. It is thus possible to improve infrared light receiving properties more effectively. A range of infrared light emitted onto a detection object and a range of infrared light reflected by the detection object are, however, narrowed, and, therefore, the inclined angle of the inner wall of the first pore 104 and the inclined angle of the inner wall of the second pore 105 are determined such that a condition (distance between a portable terminal and a detection objet) actually used in a portable terminal is optimized.

Preferably, the photosensor package according to the embodiment of the present invention includes the light-blocking body 117 between the second opening 108 and the fourth opening 110 in the recess 106. Due to such a structure, it is possible to suppress occurrence of a malfunction as a result of a portion of infrared light emitted by the light-emitting element 114 being directly received by the light-receiving element 112. In other words, it is possible to suppress infrared light emitted by the light-emitting element 114 from being directly detected by the light-receiving element 112 without being reflected by a detection object and from causing a malfunction.

Specifically, a heat-curable resin that contains a silicon resin or an epoxy resin as a main component, filler components such as ZnO (filler) and carbon black (additive) that improve light blocking properties by absorbing or reflecting infrared light, and a curing agent made of an acid anhydride group or the like may be used as the light-blocking body 117. If an epoxy resin is used as the light-blocking body 117, the epoxy resin is, for example, a bisphenol-A epoxy resin, a bisphenol-F epoxy resin, an alicyclic epoxy resin, or the like, but is not limited thereto. Among these resins, the epoxy resin, which is in a liquid state at room temperature, is preferable because such an epoxy resin is easily applicable.

The light-blocking body 117 is disposed between the second opening 108 and the fourth opening 110 in the recess 106 by, for example, disposing a plurality of solder bumps on the main surface of the light-receiving element 112 facing the recess 106 and by applying a heat-curable resin that serves as the light-blocking body 117 onto a portion between the second opening 108 and the fourth opening 110 in the recess 106 by using a dispenser or the like if the light-receiving element 112 including the light-receiving part 111 is accommodated in the recess 106. Consequently, it is possible to connect the light-receiving element 112 and the plurality of wiring conductors on the inner surface of the recess 106 to each other via the solder bumps or the like and to dispose the light-blocking body 117 between the second opening 108 and the fourth opening 110.

Specifically, it is possible to position the plurality of solder bumps of the light-receiving element 112 at the plurality of wiring conductors on the inner surface of the recess 106 and connect the solder bumps thereto and to dispose the heat-curable resin so as to fill a gap between the light-receiving element 112 and the bottom portion of the recess 106 in a portion between the second opening 108 and the fourth opening 110 in the recess 106.

Heat-curable resins that have resistance to heat at a temperature higher than a heating temperature of a bonding material of a solder or the like for connecting the light-receiving element 112 and that complete heat curing at the heating temperature are usable as the heat-curable resin. These resins to be used for the light-blocking body 117 desirably have insulating properties. This is because there is a possibility that the heat-curable resin may come into contact with the plurality of wiring conductors or the solder bumps and that a short circuit may occur if the light-receiving element 112 and the plurality of wiring conductors are connected to each other via the solder bumps or the like.

Infrared light directly emitted from the light-emitting element 114 without being reflected by a detection object is blocked by the thus disposed light-blocking body 117 and is suppressed from being detected by the light-receiving part 111 of the light-receiving element 112. It is thus possible to avoid malfunction.

The photosensor device 100 according to the embodiment of the present invention includes any one of the aforementioned photosensor packages (including the wiring board 101 and the external connection conductors 115); the light-receiving element 112 including the light-receiving part 111, the light-receiving element 112 being accommodated in the recess 106; and the light-emitting element 114 including the light-emitting part 113 accommodated in the fourth opening 110, the light-emitting element 114 being placed on the light-receiving element 112. Due to such a structure, it is not necessary for the wiring board 101 to include an intermediate insulating layer or an intermediate insulating part for accommodating the light-emitting element 114 and the light-receiving element 112. It is thus possible to reduce the height of the photosensor device 100.

In other word, it is possible to configure the wiring board 101 so as to include an insulating layer or an insulating part having the first pore 104 and the second pore 105 and disposed on the first main surface 102 and so as to include an insulating layer or an insulating part having the recess 106 and disposed on the second main surface 103. Consequently, it is not necessary for the wiring board 101 to include an intermediate insulating layer or an intermediate insulating part for accommodating the light-emitting element 114. It is thus possible to reduce the height of the wiring board 101.

The photosensor device 100 illustrated in sectional view in Fig. 1 has a structure in which the metal layer 116 is not disposed on the inner surface of the second pore 105. Due to omission of the metal layer 116, there is a possibility that an infrared light collection effect that should be exhibited by the metal layer 116 on the inner surface of the second pore 105 may not be exerted if the light-emitting element 114 that emits infrared light is used. However, if a laser diode (light-emitting element that emits infrared light of approximately 850 nm) is used for the light-emitting element 114, the rectilinearity of emitted infrared light is high, and therefore, the intensity of the infrared light that reaches a detection object is high even in the structure in which the metal layer 116 is not disposed on the inner surface of the second pore 105, and reflected infrared light is easily detected by the light-receiving part 111. Accordingly, it is possible to improve detection sensitivity of the photosensor device 100 with respect to a detection object.

The photosensor device 100 according to the embodiment of the present invention includes the light-receiving part 111 disposed inside the second opening 108, and the light-emitting part 113 disposed inside the fourth opening 110 in the plan view of the aforementioned photosensor device 100. Due to such a structure, infrared light reflected by a detection object is not blocked around the second opening 108 and is easily detected by the light-receiving part 111. Moreover, a portion of infrared light emitted by the light-emitting element 114 is not blocked around the fourth opening 110.

In other words, the light-emitting part 113 that is disposed inside the fourth opening 110 enables a detection object to be efficiently irradiated with infrared light emitted by the light-emitting element 114. In addition, the light-receiving part 111 that is disposed inside the second opening 108 enables infrared light reflected by the detection object to be efficiently detected by the light-receiving part 111.

As illustrated in Figs. 1 to 5, the light-receiving part 111 is integrally formed by being embedded in a portion of the light-receiving element 112. Accordingly, the light-receiving part 111 does not easily come into contact with the bottom portion of the recess 106 if the light-receiving element 112 is accommodated in the recess 106.

The light-emitting element 114 has a structure in which, for example, the circumference of the light-emitting part 113 is covered with, for example, a transparent resin having light collecting properties. The light-emitting element 114 is connected as a chip component to a portion of the light-receiving element 112. Thus, the light-emitting element 114 projects from the main surface of the light-receiving element 112, and a projecting portion of the light-emitting element 114 is inserted into the fourth opening 110 of the second pore 105. Due to a combined effect of the transparent resin having the light collecting properties and the light-emitting element 114 inserted into the fourth opening 110, it is possible for a detection object to be efficiently irradiated with infrared light. Therefore, it is possible to provide the photosensor device 100 that has high detection sensitivity and that includes the light-receiving part 111 capable of efficiently detecting infrared light reflected by a detection object.

The photosensor device 100 according to the embodiment of the present invention includes the light-receiving element 112 that is placed in the recess 106 in the aforementioned photosensor device 100. Due to such a structure, if an external force is applied to a motherboard (not illustrated), a stress is not easily transmitted to the light-receiving element 112. It is thus possible to provide the photosensor device 100 having good operational reliability.

In other words, even if a module substrate 118 disposed on which the photosensor device 100 is placed is mounted on the motherboard via a mounting electrode 120 and an external force is applied thereto, the stress of the external force is not easily transmitted to the light-receiving element 112 placed in the recess 106 of the wiring board 101 while the stress is transmitted to the plurality of external connection conductors 115 disposed on the second main surface 103 of the wiring board 101 via solder. Thus, occurrence of damage on the light-receiving element 112 and occurrence of light-emission failure in the light-emitting element 114 disposed on the light-receiving element 112 due to disconnection or the like are suppressed, and it is thus possible to provide the photosensor device 100 having good operational reliability.

It is possible to configure the wiring board 101 so as to include an insulating layer or an insulating part having the first pore 104 and the second pore 105 and disposed on the first main surface 102 and so as to include an insulating layer or an insulating part having the recess 106 and disposed on the second main surface 103. It is thus possible to provide the low-height compact photosensor device 100 that includes the wiring board 101 in which the light-receiving element 112 including the light-receiving part 111 is placed in the recess 106 by being placed at the bottom portion of the recess 106 of the second main surface 103 by flip-chip connection and in which the light-emitting element 114 including the light-emitting part 113 is accommodated in the fourth opening 110; and the plurality of external connection conductors 115 on the wiring board 101.

As illustrated in Figs. 1 to 4, the light-receiving element 112 is placed in the recess 106 by flip-chip connection in the photosensor device 100. The wiring board 101 includes the wiring conductors (not illustrated) extending from the bottom portion of the recess 106 to the outer surface of the second main surface 103. The light-emitting element 114 is placed on the placement portion (region inside the fourth opening 110 of the second pore 105 in plan view) for the light-emitting element 114, the placement portion being disposed on the upper surface of the light-receiving element 112, and the light-receiving element 112 is placed in the recess 106 by flip-chip connection, thereby constituting the photosensor device 100 according to the embodiment of the present invention. If the light-receiving element 112 is placed in the recess 106 of the wiring board 101, the light-receiving part 111 is positioned at the bottom portion of the first pore 104 and the light-emitting element 114 placed on the upper surface of the light-receiving element 112 is positioned at the bottom portion of the second pore 105.

The plurality of external connection conductors 115 is disposed on the second main surface 103 of the wiring board 101. The plurality of external connection conductors 115 of the wiring board 101 is electrically connected to the electronic-module substrate 118 and the like by a bonding material such as solder. In sectional view, the main surface of the light-receiving element 112 placed in the recess 106 on the second main surface 103 side is desirably positioned closer than the second main surface 103 of the wiring board 101 to the first main surface 102. In other words, if the plurality of external connection conductors 115 of the wiring board 101 is connected to the electronic-module substrate 118 and the like, the main surface of the light-receiving element 112 on the second main surface 103 side is arranged away from the main surface of the electronic-module substrate 118 or the like. It is thus possible to suppress occurrence of damage or occurrence of malfunction of the photosensor device 100 as a result of contact or a short circuit. The light-receiving element 112 in the recess 106 may be covered with a potting resin or the like in a state in which the wiring board 101 is vertically inverted. Consequently, it is possible to suppress occurrence of damage or occurrence of malfunction of the photosensor device 100 as a result of contact or a short circuit more effectively.

An electronic module 130 according to the embodiment of the present invention includes the module substrate 118 including a connection conductor 119; and the photosensor device 100 including the aforementioned configuration, the light-receiving element 112 is disposed on the module substrate 118, and the plurality of external connection conductors 115 are connected to the connection conductor 119.

Due to such a structure, it is possible to improve mountability of the light-receiving element 112 onto the module substrate 118. In other words, for example, instead of placing the light-receiving element 112 on the photosensor package by placing the light-receiving element 112 at the bottom portion of the recess 106 after vertically inverting the photosensor package to place the recess 106 to face upward, it is possible to place the light-receiving element 112 and the photosensor package (wiring board 101) on the module substrate 118 without vertically inverting the photosensor package. The module substrate 118 on which the light-receiving element 112 is placed has a flat-plate shape and has an upper surface that is not covered with a structure such as the wiring board 101. It is thus possible to easily place the light-emitting element 114 at a predetermined position in the light-receiving element 112 by using a placement head of a part placing device.

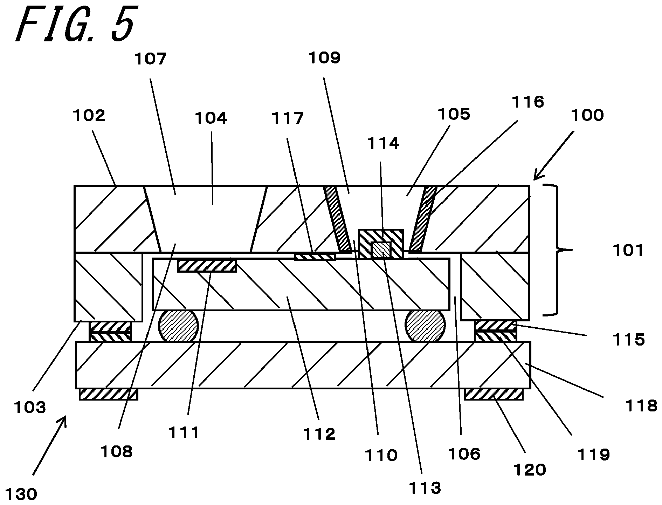

The external connection conductors 115 of the wiring board 101 are connected to the connection conductor 119 of the electronic-module substrate 118 on which the light-emitting element 114 and the light-receiving element 112 are placed, thereby constituting the electronic module 130, illustrated in Fig. 5, according to the embodiment of the present invention. The light-emitting element 114 may be connected to the light-receiving element 112 by being directly connected by flip-chip connection to the wiring conductors on the main surface of the light-receiving element 112. Moreover, the light-emitting element 114 may be placed on the light-receiving element 112 and then electrically connected to a bonding terminal (not illustrated) of the wiring board 101 by wire-bonding connection.

Fig. 5 illustrates an example in which the terminal (not illustrated) of the light-emitting element 114 is connected to the connection terminal (not illustrated) of the light-receiving element 112; however, such a structure is a non-limiting example. For example, a step portion (not illustrated) may be disposed on the inner wall of the second pore 105 of the ceramic green sheet that serves as the first main surface 102, a connection terminal for bonding (not illustrated) may be disposed on the step portion, and the terminal of the light-receiving element 112 and the connection terminal for bonding on the step portion may be connected to each other by wire bonding. If an illuminance sensor (not illustrated) is placed on the step portion, it is possible to provide the electronic module 130 that has a proximity sensing function and an illuminance sensing function that controls backlight of a liquid crystal screen to detect illuminance and save electric power. Due to such a connection method, it is possible to provide the electronic module 130 in which the connection terminal for bonding on the wiring board 101 and the terminal of the light-receiving element 112 are favorably connected to each other.

The electronic module 130 according to the embodiment of the present invention includes the module substrate 118 including the connection conductor 119; and the photosensor device 100 including the aforementioned configuration, the plurality of external connection conductors 115 are connected to the connection conductors 119. Due to such a structure, if an external force is applied to the motherboard, a stress is not easily transmitted to the light-receiving element 112. It is thus possible to provide the electronic module 130 having good operational reliability.

The module substrate 118 on which the photosensor device 100 is placed is mounted on the motherboard via the mounting electrode 120. If an external force is applied to the motherboard, a stress is transmitted to the electronic-module substrate 118, and the stress is further transmitted via solder to the plurality of external connection conductors 115 on the second main surface 103 of the wiring board 101. The external connection conductors 115 of the wiring board 101 and the connection conductor 119 of the electronic-module substrate 118 are connected to each other via the solder. The stress from the module substrate 118 is reduced by the solder disposed between the wiring board 101 and the electronic-module substrate 118 and is transmitted to the wiring board 101. Accordingly, the stress is more effectively suppressed from being transmitted to the light-receiving element 112 in the recess 106 of the wiring board 101. Therefore, occurrence of damage on the light-receiving element 112 and occurrence of light-emission failure in the light-emitting element 114 disposed on the light-receiving element 112 as a result of disconnection or the like are suppressed. It is thus possible to provide the photosensor device 100 having good operational reliability.

If there is provided only the aforementioned photosensor device 100, the lower surface of the light-receiving element 112 is exposed on the second main surface 103 side of the wiring board 101; however, due to the structure in which the recess 106 of the wiring board 101 is covered with the module substrate 118, it is possible to suppress the light-receiving element 112 from being damaged by accident by coming into contact with a jig or the like during mounting of the photosensor device 100 onto the motherboard or the like and from causing light-emission failure. Therefore, it is possible to provide the electronic module 130 having good mounting reliability.

Note that the photosensor package, the photosensor device 100, and the electronic module 130 according to the embodiment of the present invention are not limited to the above examples of the embodiment; various modifications may be added thereto within a scope not deviating from the outline of the present invention. In the aforementioned examples of the embodiment, the width of the first opening 107 is larger than the width of the second opening 108 and the width of the third opening 109 is larger than the width of the fourth opening 110 in the sectional view of the first pore 104 and the second pore 105 in the wiring board 101; however, the width of the first opening 107 and the width of the second opening 108 may be identical to each other and the width of the third opening 109 and the width of the fourth opening 110 may be identical to each other. Moreover, each of the shape of the wiring board 101 constituting the photosensor device 100 and the shape of the module substrate 118 in plan view is not limited to a rectangular shape and may be a square shape, an octagonal shape, a circular shape, an oval shape, or the like.

It is described above that the photosensor package, the photosensor device 100, and the electronic module 130 according to the embodiment of the present invention are applicable to a proximity sensor device; however, the photosensor package, the photosensor device 100, and the electronic module 130 are also applicable to another device, for example, a proximity-illuminance integrated sensor device, a distance measuring sensor device, a pulse-wave and blood-flow sensor device, or the like, that is operated by the pair of sensor elements of the light-emitting element 114 and the light-receiving element 112.

## Claims

1. A photosensor package comprising:
a wiring board comprising
a first main surface,
a second main surface opposite to the first main surface,
a first pore and a second pore extending therethrough from the first main surface to the second main surface, the first pore comprising a first opening in the first main surface and a second opening in the second main surface, the second pore comprising a third opening in the first main surface and a fourth opening in the second main surface, the fourth opening accommodating a light-emitting element comprising a light-emitting part, and
a recess in the second main surface by which the first pore and the second pore are in communication with each other, the recess accommodating a light-receiving element comprising a light-receiving part; and
a plurality of external connection conductors on the wiring board.

2. The photosensor package according to claim 1, wherein the second pore comprises a metal layer on an inner surface thereof.

3. The photosensor package according to claim 1 or claim 2, wherein a width of the first opening is larger than a width of the second opening and a width of the third opening is larger than a width of the fourth opening.

4. The photosensor package according to claim 3, wherein a width of the first pore increases gradually from the second opening to the first opening, and a width of the second pore increases gradually from the fourth opening to the third opening.

5. The photosensor package according to any one of claims 1 to 4, comprising:
a light-blocking body between the second opening and the fourth opening in the recess.

6. A photosensor device comprising:
the photosensor package according to any one of claims 1 to 5;
a light-receiving element in the recess, the light-receiving element comprising a light-receiving part; and
a light-emitting element disposed on the light-receiving element, the light-emitting element accommodated in the fourth opening, and comprising a light-emitting part.

7. The photosensor device according to claim 6, wherein the light-receiving part is disposed inside the second opening, and the light-emitting part is disposed inside the fourth opening in plan view.

8. The photosensor device according to claim 6 or claim 7, wherein the light-receiving element is in the recess.

9. An electronic module comprising:
a module substrate comprising a connection conductor; and
the photosensor device according to claim 6 or claim 7, wherein the light-receiving element is disposed on the module substrate, and the plurality of external connection conductors are connected to the connection conductor.

10. An electronic module comprising:
a module substrate comprising a connection conductor; and
the photosensor device according to claim 8, wherein the plurality of external connection conductors are connected to the connection conductor.
